# EUROPEAN PATENT SPECIFICATION

(11) **EP 2 268 849 B1**
(45) Date of publication and mention of the grant of the patent: **10.04.2013**
(21) Application number: 09719293.4
(22) Date of filing: 18.02.2009
(51) Int. Cl.: C23C 16/453, C03C 17/00, C23C 16/40

(54) **IN SITU NANO-PARTICLE MATRIX LOADING OF METAL OXIDE COATINGS VIA COMBUSTION DEPOSITION**
IN-SITU-NANOPARTIKELMATRIXBELADUNG VON METALLOXIDÜBERZÜGEN MITTELS VERBRENNUNGSABSCHEIDUNG
CHARGEMENT IN SITU DE MATRICES DE NANOPARTICULES DE REVÊTEMENTS À BASE D'OXYDE MÉTALLIQUE PAR DÉPÔT PAR COMBUSTION

(30) Priority: 13.03.2008 US 76101
(43) Date of publication of application: 05.01.2011
(73) Proprietor: Guardian Industries Corp., Auburn Hills, MI 48326-1714 (US)
(72) Inventor: LEWIS, Mark, A., Ypsilanti MI 48197 (US); MCLEAN, David, D., Hazel Park MI 48030 (US)
(74) Representative: Hess, Peter K. G.
(86) International application number: PCT/US2009/001002
(87) International publication number: WO 2009/114060

(56) References cited:
- EP-A- 0 607 884
- EP-A- 1 602 633
- DE-A1- 10 206 330

## Description

### FIELD OF THE INVENTION

This invention relates to the deposition of metal oxide coatings onto substrates via combustion deposition. More particularly, certain example embodiments relate to in situ nano-particle matrix loading of metal oxide coatings via combustion deposition. In certain example embodiments, the metal oxide coating may be a silicon oxide coating (e.g., SiO₂, or other suitable stoichiometry) and, in certain example embodiments, the silicon oxide coating may serve as an anti-reflective (AR) coating. In certain example embodiments, a percent visible transmission gain of at least about 2.0%, and more preferably between about 3.0-3.25%, may be realized through the growth of multiple films on a first surface of the substrate.

### BACKGROUND AND SUMMARY OF EXAMPLE EMBODIMENTS OF THE INVENTION

Combustion chemical vapor deposition (combustion CVD) is a relatively new technique for the growth of coatings. Combustion CVD is described, for example, in U.S. Patent Nos. 5,652,021; 5,858,465; and 6,013,318, each of which is hereby incorporated herein by reference in its entirety.

Conventionally, in combustion CVD, precursors are dissolved in a flammable solvent and the solution is delivered to the burner where it is ignited to give a flame. Such precursors may be vapor or liquid and fed to a self-sustaining flame or used as the fuel source. A substrate is then passed under the flame to deposit a coating.

Such conventional combustion CVD process for depositing a single layer anti reflecting coating is also known from EP 1602 633 A1. A homogeneous silicon oxide layer is deposited using hydrocarbon gas or hydrogen and a silicon inclusive precursor. The layer can be deposited using one or multiple deposition cycles.

There are several advantages of combustion CVD over traditional pyrolytic deposition techniques (such as CVD, spray and sol-gel, etc.). One advantage is that the energy required for the deposition is provided by the flame. Another advantage is that combustion CVD techniques do not necessarily require volatile precursors. If a solution of the precursor can be atomized/nebulized sufficiently (e.g., to produce droplets and/or particles of sufficiently small size), the atomized solution will behave essentially as a gas and can be transferred to the flame without requiring an appreciable vapor pressure from the precursor of interest.

It will be appreciated that combustion deposition techniques may be used to deposit metal oxide coatings (e.g., single-layer anti-reflective coatings) on glass substrates, for example, to alter the optical properties of the glass substrates (e.g., to increase visible transmission). To this end, conventional combustion deposition techniques were used by the inventors of the instant application to deposit a single layer anti-reflective (SLAR) film of silicon oxide (e.g., SiO₂ or other suitable stoichiometry). The attempt sought to achieve an increase in light transmission in the visible spectrum (e.g., wavelengths of from about 400-700 nm) over clear float glass with an application of the film on one or both sides of a glass substrate. In addition, increases in light transmission for wavelengths greater the 700 nm are also achievable and also may be desirable for certain product applications, such as, for example, photovoltaic solar cells. The clear float glass used in connection with the description herein is a low-iron glass known as "Extra Clear," which has a visible transmission typically in the range of 90.3% to about 91.0%. Of course, the examples described herein are not limited to this particular type of glass, or any glass with this particular visible transmission.

The combustion deposition development work was performed using a conventional linear burner. As is conventional, the linear burner was fueled by a premixed combustion gas comprising propane and air. It is, of course, possible to use other combustion gases such as, for example, natural gas, butane, etc. The standard operating window for the linear burner involves air flow rates of between about 150 and 300 standard liters per minute (SLM), using air-to-propane ratios of about 15 to 25. Successful coatings require controlling the burner-to-lite distance to between about 10-50mm when a linear burner is used.

Typical process conditions for successful films used a burner air flow of about 225 SLM, an air-to-propane ratio of about 19, a burner-to-lite distance of 35 mm, and a glass substrate velocity of about 50 mm/sec.

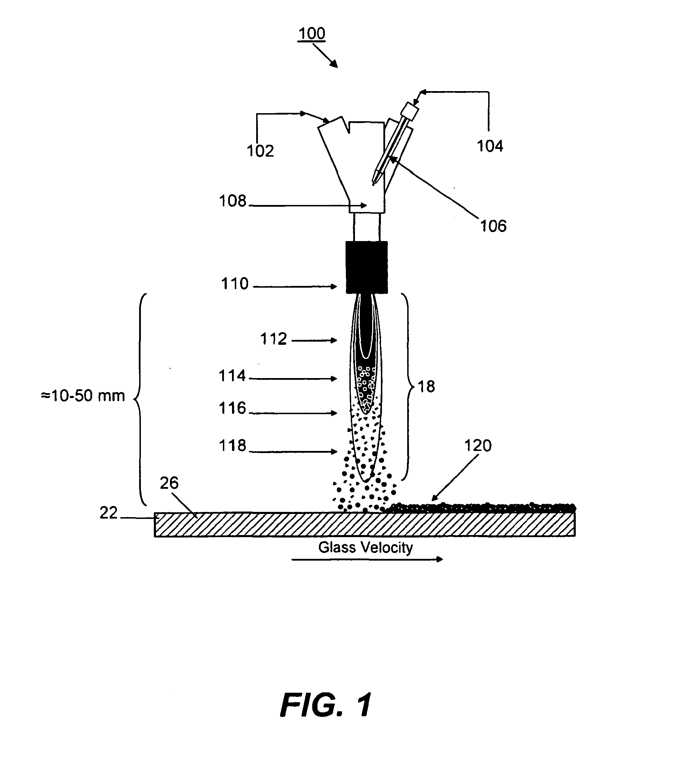

Fig. 1 is a simplified view of an apparatus 100 including a linear burner used to carry out combustion deposition. A combustion gas 102 (e.g., a propane air combustion gas) is fed into the apparatus 100, as is a suitable precursor 104 (e.g., via insertion mechanism 106, examples of which are discussed in greater detail below). Precursor nebulization (108) and at least partial precursor evaporation (110) occur within the apparatus 100 and also may occur external to the apparatus 100, as well. The precursor could also have been delivered as a vapor reducing or even eliminating the need for nebulization The flame 18 may be thought of as including multiple areas. Such areas correspond to chemical reaction area 112 (e.g., where reduction, oxidation, and/or the like may occur), nucleation area 114, coagulation area 116, and agglomeration area 118. Of course, it will be appreciated that such example areas are not discrete and that one or more of the above processes may begin, continue, and/or end throughout one or more of the other areas.

Particulate matter begins forming within the flame 18 and moves downward towards the surface 26 of the substrate 22 to be coated, resulting in film growth 120. As will be appreciated from Fig. 1, the combusted material comprises non-vaporized material (e.g., particulate matter), which is also at least partially in particulate form when coming into contact with the substrate 22. To deposit the coating, the substrate 22 may be moved (e.g., in the direction of the velocity vector). Of course, it will be appreciated that the present invention is not limited to any particular velocity vector, and that other example embodiments may involve the use of multiple apparatuses 100 for coating different portions of the substrate 22, may involve moving a single apparatus 100 while keeping the substrate in a fixed position, etc. The burner 110 is about 10-50 mm from the surface 26 of the substrate 22 to be coated.

Using the above techniques, the inventor of the instant application was able to produce coatings that provided a percent change in Tᵥᵢₛ gain of 1.96% over the visible spectrum when coated on a single side of clear float glass. The percent change in Tᵥᵢₛ gain may be attributable in part to some combination of surface roughness increases and air incorporation in the film that yields a lower effective index of refraction.

Although a percent change in Tᵥᵢₛ gain of about 2% is advantageous, further improvements are still possible. For example, optical modeling of these layers suggests that an index of refraction of about 1.33 for coatings that are about 100 nm thick should yield a percent change in Tᵥᵢₛ gain of about 3.0-3.5%. The index of refraction of bulk density (e.g., no or substantially no air incorporation) is nominally between about 1.45-1.5.

Furthermore, it would be desirable to approximate the properties obtained via sol-gel techniques. Sol-gel derived coatings of metal oxides (e.g., of silicon oxide) have been found to provide an increase in transmission of nominally about 3.5% over the visible spectrum when coated on a single side of clear float glass. For example, sol-gel coatings having a silicon oxide (e.g., SiO₂ or other suitable stoichiometry) based matrix which had silica nano-particles embedded therein were produced. The interaction of the silicon oxide matrix with the nano-particles produced a microstructure that gave rise to coating's excellent AR properties.

Thus, it will be appreciated that there is a need in the art for improved techniques for depositing metal oxide coatings (e.g., anti-reflective coatings of, for example, silicon oxide) on glass substrates via combustion deposition, for combustion deposition techniques that yield coatings exhibiting properties comparable to those produced by the sol-gel processes noted above, and/or for metal oxide coatings having improved microstructures (e.g., metal oxide coatings having nano-particles embedded therein). It also may be possible to use the techniques described herein as a different method for controlling microstructures, in general. The invention provides a solution according to the independent claims.

According to certain example embodiments, to improve the percent change in Tᵥᵢₛ gain beyond the current levels of 1.96%, metal oxide coatings (e.g., silicon oxide coatings) may be produced using techniques that cause the microstructure of the coatings to emulate the microstructures of sol gel deposited coatings. The coatings produced in accordance with certain example embodiments possess an enhanced transmission increase over previously combustion deposition produced single-layer anti-reflective (SLAR or single-layer AR) coatings. This may be accomplished in certain example embodiments by providing intermixed or graded metal oxide coatings (e.g., silicon oxide growths that alternate between process conditions that produce small nucleation particle size distributions and large agglomerate nano-particle size distributions) and/or by in situ nano-particle matrix loading of metal oxide coatings via combustion deposition. It may be accomplished in certain example embodiments by providing two or more growths, the growths generally alternating between process conditions that produce small nucleation particle size distributions and large agglomerate nano-particle size distributions growths where there are an increased number of air gaps with increased particle size, thereby reducing the index of refraction of the layer, or vice versa.

In one embodiment of this invention, a method of forming a coating on a glass substrate using combustion deposition is provided, as disclosed in claim 1.

In an other embodiment, there is provided a coated article including a coating supported by a glass substrate, as disclosed in claim 8.

The features, aspects, advantages, and example embodiments described herein may be combined to realize yet further embodiments.

### BRIEF DESCRIPTION OF THE DRAWINGS

These and other features and advantages may be better and more completely understood by reference to the following detailed description of exemplary illustrative embodiments in conjunction with the drawings, of which:

FIGURE 1 is a simplified view of an apparatus including a linear burner used to carry out combustion deposition;

FIGURE 2 is a simplified view of a two burner system used to carry out combustion deposition in accordance with an example embodiment;

FIGURE 3 is a simplified view of a three burner system used to carry out combustion deposition in accordance with an example embodiment;

FIGURE 4 is a coated article including a coating supported by a substrate in accordance with an example embodiment; and

FIGURE 5 is an illustrative flowchart illustrating a process for applying an anti-reflective (AR) coating to a glass substrate using combustion deposition in accordance with an example embodiment.

### DETAILED DESCRIPTION OF EXAMPLE EMBODIMENTS OF THE INVENTION

In certain example embodiments of this invention, a method of forming a coating on a glass substrate using combustion deposition is provided. A glass substrate having at least one surface to be coated is provided. A reagent is selected, with the reagent being selected such that at least a portion of the reagent is used in forming the coating. A first precursor to be combusted by a first flame is introduced. At least a portion of the reagent and the first precursor are combusted to form a first combusted material, with the first combusted material comprising non-vaporized material. The glass substrate is provided in a first area so that the glass substrate is heated sufficiently to allow the first combusted material to form a first growth directly or indirectly, on the glass substrate. A second precursor to be combusted by a second flame is introduced. At least a portion of the reagent and the second precursor are combusted to form a second combusted material, the second combusted material comprising non-vaporized material. The glass substrate is provided in a second area so that the glass substrate is heated sufficiently to allow the second combusted material to form a second growth directly or indirectly, in or on the first growth. The coating comprises at least the first and second growths, with the first growth using process conditions that produce small nucleation particle size distributions and the second growth using process conditions that produce large agglomerate nano-particle size distributions.

In certain example embodiments, there is provided a coated article including a coating supported by a glass substrate. At least two combustion deposition deposited growths are arranged such that the growths collectively comprise a film composition mixture of small nucleation size particles and agglomerated larger nano particles. The at least two combustion deposition deposited growths collectively form a metal oxide matrix including nano-particles, with the nano-particles being embedded therein in situ. The coating increases visible transmission of the glass substrate by at least about 2.0% and, more preferably, by between about 3.0-3.25%.

In certain example embodiments, a method of making a coated article including a coating supported by a glass substrate is provided. A metal oxide matrix including in situ embedded nano-particles is formed. The metal oxide matrix is formed by growing a film using process conditions that produce small nucleation particle size distributions via combustion deposition directly or indirectly on the glass substrate and growing a film using process conditions that produce large agglomerate nano-particle size distributions via combustion deposition directly or indirectly in or on the film made using process conditions that produce small nucleation particle size distributions.

In certain example embodiments, a fuel gas and oxygen source is selected and mixed together to form a combustion gas mixture. At least a portion of the combustion gas mixture is used in forming the coating. First and second precursors are selected such that at least a portion of the combustion products form a coating with desired properties. The precursors are introduced into the combustion gas stream to form a reagent mixture. Using at least first and second flames, at least a portion of the reagent mixture is reacted via combustion to form reaction products, with at least a portion of the reaction products comprising non-vaporized material. Films produced by the first and second precursors are grown on the substrate such that a coating is produced, the coating comprising a mixture of generally alternating depositions with process conditions that produce small nucleation particle size distributions and process conditions that produce large agglomerate nano-particle size distributions. The coating increases visible transmission of the glass substrate by at least about 2.0% and, more preferably, by between about 3.0-3.25%.

In certain example embodiments, to improve the percent change in Tᵥᵢₛ gain beyond the current levels of 1.96%, metal oxide coatings (e.g., silicon oxide coatings) may be produced using techniques that cause the microstructure of the coatings to emulate the microstructures of sol gel deposited coatings. The coatings produced in accordance with certain example embodiments possess an enhanced transmission increase over previously combustion deposition produced single-layer anti-reflective (SLAR or single-layer AR) coatings. This may be accomplished in certain example embodiments by provided mixed or graded metal oxide coatings (e.g., silicon oxide growths that alternate between process conditions that produce small nucleation particle size distributions and process conditions that produce large agglomerate nano-particle size distributions) and/or by in situ nano-particle matrix loading of metal oxide coatings via combustion deposition. It may be accomplished in certain example embodiments by providing two or more growths, the growths generally alternating between growths made with process conditions that produce small nucleation particle size distributions where there are a reduced number of air gaps and growths made with process conditions that produce large agglomerate nano-particle size distributions where the increased particle size in the films tend to result in an increased number of air gaps, or vice versa.

Certain example embodiments use two or more burner systems that are operated at a number of different process conditions. A first burner is operated at conditions that produce small nucleation particle size distributions growths or films, typically less than about 30 nm, more preferably less than about 10 nm or even smaller, for silicon oxide based coatings. Such growths or films may be achieved using low concentrations of precursor in the combustion stream. A second burner is operated at conditions that produce a distribution of nano-particles (e.g., in the range of about 100-1500 angstroms) that typically produce less dense growths or films with an index of refraction range of about 1.25-1.42 for silicon oxide based coatings. Such growths or films may be achieved using high concentrations of precursor in the combustion stream. The second burner may be operated at conditions similar to the initial burner that typically produce smaller particle size distributions. In certain example implementations, the process conditions include a flame temperature of between about 1000-1400°C, an air-to-propane ratio of about 15-30, and an air flow rate of between about 100-300 standard liters per minute.

Silicon oxide (e.g., SiO₂ or other suitable stoichiometry) coatings made in accordance with certain example embodiments may use the precursor hexamethyldisiloxane (HMDSO) or decamethylcyclopentasiloxane (or D5). Other precursors, such as tetraethylorthosilicate (TEOS), silicon tetrachloride (e.g., SiCl₄ or other suitable stoichiometry), and the like, may be used. Of course, it will be appreciated that other metal oxide precursors may be used, for example, as the invention is not limited to deposition of silicon dioxide coatings. A "high" concentration of precursor solution includes a concentration of precursor between about 3-4 times the concentrations of precursor in a "low" concentration of precursor solution.

The resulting coating therefore may contain a metal oxide matrix (e.g., a silicon oxide matrix) with in situ grown embedded nano-particles. The coating will possess a microstructure similar to that of coatings produced by sol-gel and provide enhanced anti-reflective properties and perhaps enhanced chemical and/or mechanical durability when compared to coatings deposited with constant process conditions alone. Such properties may include, for example, reduced reflection and/or increased visible transmission or increased light transmission at higher wavelengths.

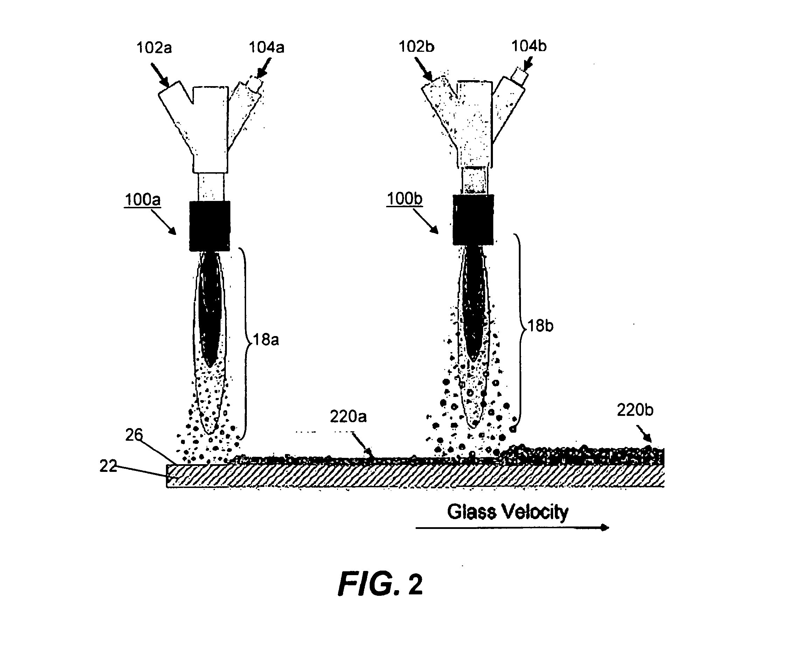

Fig. 2 is a simplified view of a two burner system used to carry out combustion deposition in accordance with an example embodiment. Fig. 2 is similar to Fig. 1, except that first and second burners 100a and 100b are used to deposit metal oxide onto the substrate 22. More particularly, a suitable combustion gas 102a is fed into a first burner 100a along with a first precursor 104a. The first precursor 104a is selected so that, when combusted by the first flame 18a, a growth made with process conditions that produce small nucleation particle size distributions is grown 220a directly or indirectly on the surface to be coated 26 of the substrate 22. Similarly, a suitable combustion gas 102b is fed into a second burner 100b along with a second precursor 104b. The second precursor 104b is selected so that, when combusted by the second flame 18b, a growth made with process conditions that produce large agglomerate nano-particle size distributions is grown 220b directly or indirectly in or on the film made with process conditions that produce small nucleation particle size distributions 220a. By way of example, the growth made with process conditions that produce small nucleation particle size distributions may have an index of refraction of about 1.43-1.46 for silicon oxide based coatings, whereas the growth made with process conditions that produce large agglomerate nano-particle size distributions may have an index of refraction of about 1.25-1.43 for silicon oxide based coatings. Thus, in certain example embodiments, nano-particles may be loaded in situ when forming the coating.

Advantageously, the technique of in situ nano-particle matrix loading allows the AR properties to be tuned to fit the product requirements. For example, the process conditions of the at least two burners may be sequentially or non-sequentially altered to affect the resulting coating.

Optionally, additional burners may be added and/or multiple passes may be made to grow a coating with alternating particle size distributions between burners and/or passes. It will be appreciated that the precursors can be the same or different between the different types of burners and respective associated conditions, e.g., to achieve a layer with a mixture of materials made with process conditions that produce small nucleation particle size distributions and materials made with process conditions that produce large agglomerate nano-particle size distributions, as appropriate.

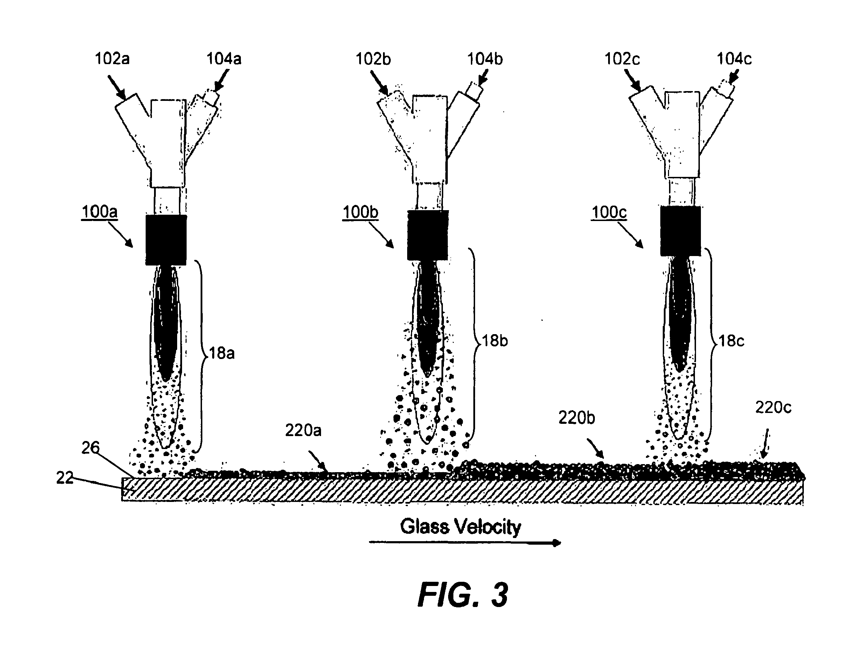

Thus, for example, Fig. 3 is a simplified view of a three burner system used to carry out combustion deposition in accordance with an example embodiment. First, second, and third burners 100a, 100b, and 100c are used to deposit metal oxide onto the substrate 22. More particularly, a suitable combustion gas 102a is fed into a first burner 100a along with a first precursor 104a. The first precursor 104a is selected so that, when combusted by the first flame 18a, a growth made with process conditions that produce small nucleation particle size distributions is grown 220a directly or indirectly on the surface to be coated 26 of the substrate 22. Similarly, a suitable combustion gas 102b is fed into a second burner 100b along with a second precursor 104b. The second precursor 104b is selected so that, when combusted by the second flame 18b, a growth made with process conditions that produce large agglomerate nano-particle size distributions is grown 220b directly or indirectly in or on the film made with process conditions that produce small nucleation particle size distributions 220a. Again, a suitable combustion gas 102c is fed into a third burner 100c along with a third precursor 104c. The third precursor 104c is selected so that, when combusted by the third flame 18c, a growth made with process conditions that produce small nucleation particle size distributions is grown 220c directly or indirectly in or on the film made with process conditions that produce large agglomerate nano-particle size distributions 220b. The first and third precursors 104a and 104c may be the same or different precursors such that the respective films to be grown 220a and 220c may be approximately the same, e.g., in terms of particle size distributions. Generally, both the first and third precursors 104a and 104c will be selected so as to allow for the growth of films made with process conditions that produce small nucleation particle size distributions than the second film growth 220b.

It will be appreciated that additional burners 100 may be used in certain example embodiments in the above-described and/or other ways to provide film growths having alternating small and larger nano-particle distributions. It also will be appreciated that multiple passes of the substrate proximate to the burners in a multiple burner system may be used to produce coatings having small and larger nano-particle distributions and/or to create a nano-particle loaded matrix.

Furthermore, a single burner may be used to produce coatings having small and larger nano-particle distributions and/or to create a nano-particle loaded matrix in certain example embodiments. The single burner therefore may operate in least two modes, with at least a first mode being responsible for film growth using process conditions that produce small nucleation particle size distributions and a second mode being responsible for film growth using process conditions that produce large agglomerate nano-particle size distributions. In one such example implementation, the substrate 22 may be made to make multiple passes under a single burner with the precursor and/or other process conditions being changed on each pass so as to allow for film growths having alternating small and large particle size distributions and/or with the modes being changed at each pass. In another example implementation, a single precursor may be used, and the concentration of the precursor may be adjusted on each pass and/or in connection with each mode. For example, the concentration of precursor may start low to provide a film growth using process conditions that produce small nucleation particle size distributions in the first mode and, for example, while the substrate 22 is being prepared for a second pass, the concentration of precursor may be increased to provide film growth using process conditions that produce large agglomerate nano-particle size distributions in a second pass and/or mode. In certain example embodiments, each pass may be delayed a predetermined amount of time to enable conditions to stabilize (e.g., for the concentration of the precursor to stabilize) and/or for process conditions to be adjusted.

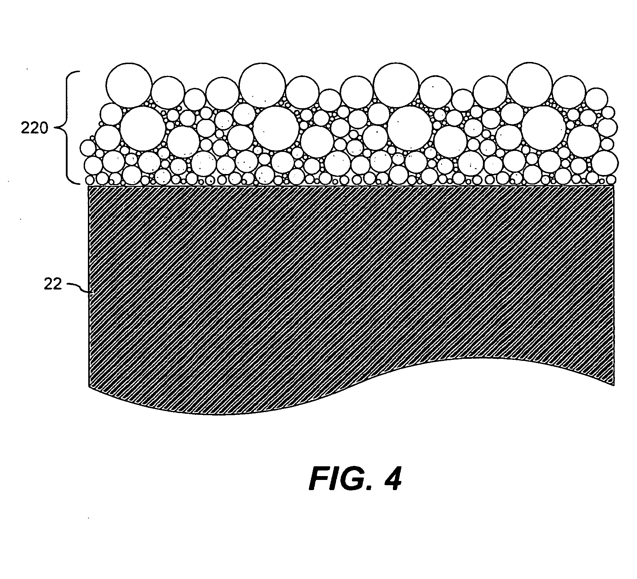

Fig. 4 is a coated article including a coating 220 supported by a substrate 22 in accordance with an example embodiment. The coating 220 is deposited by combustion deposition in one of the above-described and/or other techniques. The coating 220 is a mixture such that the refraction index can be adjusted to the desired level by varying the size distribution from the device producing the large agglomerate nano-particle size particles. In certain example embodiments, the films made with process conditions that produce small nucleation particle size distributions is located closest to the substrate 22 to improve layer adhesion. Optionally, film growths using process conditions that produce large agglomerate nano-particle size distributions may be grown on the substrate in the opposite starting order. The refraction index coating is a metal oxide coating and, in certain example embodiments, the refraction index coating is a silicon oxide index coating. Also, the metal oxide coating matrices include nano-particles embedded therein via combustion deposition.

Thus, at least two combustion deposition deposited growths (e.g., growths 220a and 220b) are arranged such that the growths collectively comprise generally mixture growth of small particle distributions and larger agglomerate particle distributions, and at least two combustion deposition deposited growths collectively form a metal oxide matrix including nano-particles, the nano-particles being embedded therein in situ. It will be appreciated that the growths are generally mixtures in the sense that the growths comprising the coating 220 are not be completely or entirely discrete. Thus, growths may be "in," "on" and/or "supported by" other growths in a generally mixed or graded manner, with some of a first or second growth possibly being located partially within a second or first growth, respectively. Furthermore, while the layer mixture or coating 220 is "on" or "supported by" substrate 22 (directly or indirectly), other layer(s) may be provided therebetween. Thus, for example, coating 220 of Fig. 4 may be considered "on" and "supported by" the substrate 22 even if other layer(s) are provided between growth 220a and substrate 22. Moreover, certain growths or layers of coating 220 may be removed in certain embodiments, while others may be added in other embodiments of this invention without departing from the overall spirit of certain embodiments of this invention.

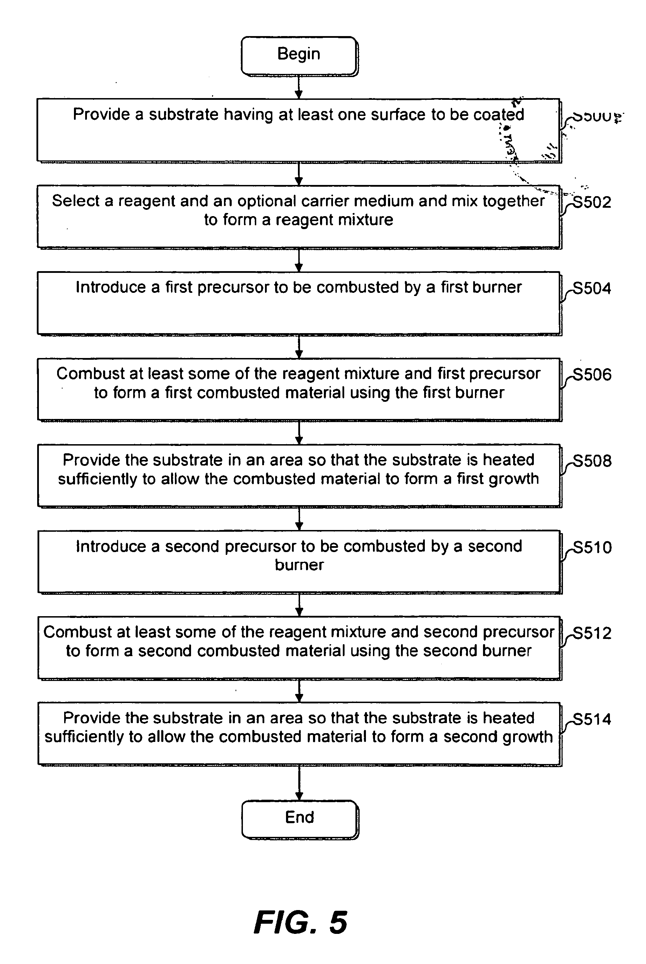

Fig. 5 is an illustrative flowchart illustrating a process for applying an anti-reflective (AR) coating to a glass substrate using combustion deposition in accordance with an example embodiment. In step S500, a substrate (e.g., a glass substrate) having at least one surface to be coated is provided. A reagent and an optional carrier medium are selected and mixed together to form a reagent mixture in step S502. The reagent is selected so that at least a portion of the reagent forms the coating. A first precursor to be combusted using a first burner is introduced in step S504. In step S506, at least a portion of the reagent mixture and the first precursor are combusted, thereby forming a first combusted material. The precursors may be introduced by a number of means. For example, the precursor may be introduced in a vapor state via a bubbler, as large particle droplets via an injector, and/or as small particle droplets via a nebulizer. In step S508, the substrate is provided in an area so that the substrate is heated sufficiently to allow the first combusted material to form a first growth on the substrate. The first growth may be formed either directly or indirectly on the substrate. The first growth may be a growth made with process conditions that produce small nucleation particle size distributions, e.g., of a metal oxide such as silicon oxide (e.g., SiO₂ or other suitable stoichiometry). A second precursor to be combusted using a first burner is introduced in step S510. In step S512, at least a portion of the reagent mixture and the second precursor are combusted, thereby forming a second combusted material. In step S514, the substrate is provided in an area so that the substrate is heated sufficiently to allow the second combusted material to form a second growth on the substrate. The second growth may be formed either directly or indirectly in or on the first growth. The second growth may be made using process conditions that produce large agglomerate nano-particle size distributions, e.g., of a metal oxide such as silicon oxide (e.g., SiO₂ or other suitable stoichiometry).

Some or all of these techniques may be repeated to provide additional growths, which may generally alternate between depositions made with process conditions that produce small nucleation particle size distributions and process conditions that produce large agglomerate nano-particle size distributions. The repetition may be accomplished using additional burners and/or by making multiple passes under two or more burners. In certain example embodiments, as noted above, a single burner operating in two or more modes may be used to accomplish similar depositions.

Also, optionally, in one or more steps not shown, the opposing surface of the substrate also may be coated. Also optionally, the substrate may be wiped and/or washed, e.g., to remove excess particulate matter deposited thereon.

In certain example embodiments, a growth made with process conditions that produce small nucleation particle size distributions may adhere to a substrate (e.g., a glass substrate) more readily than a growth made with process conditions that produce large agglomerate nano-particle size distributions. Thus, certain example embodiments have been described as alternating between depositions made with process conditions that produce small nucleation particle size distributions and process conditions that produce large agglomerate nano-particle size distributions. Yet, although certain example embodiments have been described as having growths made with process conditions that produce large agglomerate nano-particle size distributions formed "on" or "supported by" the substrate, the present invention is not so limited. Thus, certain example embodiments may alternate between depositions made with process conditions that produce small nucleation particle size distributions and process conditions that produce large agglomerate nano-particle size distributions.

It will be appreciated that the high and low refractive indices may be relative to the particular coating ultimately produced in certain example embodiments. That is, different metal oxides have different refractive indices in their respective bulk forms. Generally, a "low" or "lower" refractive index growth will have a refractive index no more than about 20% lower, and more preferably no more than about 15% lower, than a refractive index of a "high" or "higher" refractive index growth. That is, the "low" or "lower" refractive index growth will have a refractive index of about 80%, and more preferably about 85%, of the "high" or "higher" refractive index growth.

As noted, the combusted materials may include particulate matter of varying sizes. The particulate matter included in the combusted material may be individual particles or may actually be agglomerations and/or aggregations of multiple particles. Thus, when the size of the particles and/or particulate matter produced is discussed herein, the sizes refer to the total size of either the sizes of the individual particles or the total sizes of the agglomerations. Moreover, the individual particles or particle agglomerations produced may be somewhat differently sized. Accordingly, the sizes specified herein refer to respective size distribution means.

Given the above descriptions, the films of certain example embodiments may be thought of as including a layer of larger particles (e.g., made using process conditions that would produce lower index of refraction films) deposited with a layer of smaller particles (e.g., made using process conditions that would produce higher index of refraction films) acting as a "glue" to hold the larger particles in place, filling in some gaps, and also sealing in some air. The resulting film therefore may be considered a mixed or graded film, as noted above. Furthermore, in certain example embodiments, the film may get rougher as more is deposited such that it is considered a graded layer.

It will be appreciated that in certain example embodiments, the first and second precursors may be selected so as to form first and second metal oxide inclusive growths, which may be of or include the same or different metal oxides. For example, in certain example embodiments, both the first and second precursors may be selected to form silicon-inclusive growths, whereas in certain other example embodiments, a first precursor may be selected to form a silicon-inclusive growth a second precursor may be selected to form a titanium-inclusive growth.

It also will be appreciated that the techniques described herein can be applied to a variety of metal oxides, and that the present invention is not limited to any particular type of metal oxide deposition and/or precursor. For example, oxides of the transition metals and lanthanides such as, for example, Y, Ti, Zr, Hf, V, Nb, Ta, Cr, Mo, W, La, Ce, Cr, Mo, W, Mn, Fe, Ru, Co, Ir, Ni, Cu, and main group metals and metalloids such as, for example, Zn, Cd, B, Al, Ga, In, Si, Ge, Sn, Sb and Bi, and mixtures thereof can all be deposited using the techniques of certain example embodiments.

It will be appreciated that the foregoing list is provided by way of example. For example, the metal oxides identified above are provided by way of example. Any suitable stoichiometry similar to the metal oxides identified above may be produced. Additionally, other metal oxides may be deposited, other precursors may be used in connection with these and/or other metal oxide depositions, the precursor delivery techniques may be altered, and/or that other potential uses of such coatings may be possible.

Also, it will be appreciated that the techniques of the example embodiments described herein may be applied to a variety of products. That is, a variety of products potentially may use these and/or other AR films, depending in part on the level of transmission gain that is obtained. Such potential products include, for example, photovoltaic, green house, sports and roadway lighting, fireplace and oven doors, picture frame glass, etc. Non-AR products also may be produced.

The example embodiments described herein may be used in connection with other types of multiple layer AR coatings, as well. By way of example and without limitation, multiple reagents and/or precursors may be selected to provide coatings comprising multiple layers.

## Claims

1. A method of forming a coating on a glass substrate using combustion deposition, the method comprising:
providing a glass substrate having at least one surface to be coated;
selecting a reagent, the reagent being selected such that at least a portion of the reagent is used in forming the coating; introducing a first precursor to be combusted by a first flame;
combusting at least a portion of the reagent and the first precursor to form a first combusted material, the first combusted material comprising non-vaporized material; providing the glass substrate in a first area so that the glass substrate is heated sufficiently to allow the first combusted material to form a first growth directly or
indirectly, on the glass substrate; introducing a second precursor to be combusted by a second flame;
combusting at least a portion of the reagent and the second precursor to form a second combusted material, the second combusted material comprising non-vaporized material; and
providing the glass substrate in a second area so that the glass substrate is heated sufficiently to allow the second combusted material to form a second growth directly or indirectly, in or on the first growth, wherein the coating comprises at least the first and second growths, wherein the concentration of the second precursor is about 3 to 4 times higher than the concentration of the first precursor and
wherein the process conditions include a flame temperature between about 1000 to 1400° C so that the first growth has a small nucleation particle size distribution and the second growth has a larger agglomerate nano-particle size distribution,
wherein the coating comprises an oxide of silicon,
wherein the first growth has a particle size distribution mean less than 10 nm and would produce a film having an index of refraction of between 1.43-1.46 if coated independently, and
wherein the second growth has a particle size distribution mean of between 10-150 nm and would produce a film having an index of refraction of between 1.25-1.42 if coated independently.

2. The method of claim 1, wherein the coating increases visible transmission of the glass substrate by at least 2.0%.

3. The method of claim 1, wherein the coating increases visible transmission of the glass substrate by between 3.0-3.25%.

4. The method of claim 1, further providing first and second burners for respectively providing the first and second flames.

5. The method of claim 1, further comprising depositing one or more additional growths, the additional growths being made with small nucleation particle size distribution and larger agglomerate nano-particle size distributions.

6. The method of claim 1, further comprising passing the substrate under the first and/or second flames at least two times to form a coating comprising multiple growths, and wherein the multiple growths alternate small nucleation particle size distribution and larger agglomerate nano-particle size distribution.

7. The method of claim 1, further comprising depositing at least one additional coating via combustion deposition on a second surface of the glass substrate.

8. A coated article including a coating supported by a glass substrate, the coating comprising: at least two combustion deposition deposited growths being arranged such that the growths collectively comprise generally alternating small nucleation particle size distribution and larger agglomerate nano-particle size distribution, wherein the at least two combustion deposition deposited growths are arranged in a mixed or graded manner and collectively form a metal oxide matrix including nano-particles, the nano-particles being embedded therein in situ, and wherein the coating increases visible transmission of the glass substrate by at least about 2.0%, wherein the coating comprises an oxide of silicon,
wherein the first growth has a particle size distribution mean less than about 10 nm and would produce a film having an index of refraction of between about 1.43-1.46 if coated independently, and wherein the second growth has a particle size distribution mean of between about 10-150 nm and would produce a film having an index of refraction of between about 1.25-1.42 if coated independently.

## Patentansprüche

1. Ein Verfahren zum Bilden einer Beschichtung auf einem Glassubstrat unter Verwendung von Verbrennungsbeschichtung, wobei das Verfahren aufweist:
Bereitstellen eines Glassubstrats, das zumindest eine Oberfläche zum Beschichten hat;
Auswählen eines Reagens, wobei das Reagens ausgewählt ist, so dass beim Bilden der Beschichtung zumindest ein Anteil von dem Reagens benutzt wird;
Einbringen eines ersten Precursors, der durch eine erste Flamme verbrannt werden soll;
Verbrennen zumindest eines Anteils von dem Reagens und dem ersten Precursor, um ein erstes verbranntes Material zu bilden, wobei das erste verbrannte Material nichtverdampftes Material aufweist; Bereitstellen des Glassubstrats in einem ersten Bereich, so dass das Glassubstrat genügend erhitzt wird, um es dem ersten verbrannten Material zu ermöglichen, einen ersten Wuchs [growth] direkt oder indirekt auf dem Glassubstrat zu bilden;
Einbringen eines zweiten Precursors, der durch eine zweite Flamme verbrannt werden soll;
Verbrennen zumindest eines Anteils von dem Reagens und dem zweiten Precursor, um ein zweites verbranntes Material zu bilden, wobei das zweite verbrannte Material nichtverdampftes Material aufweist; und
Bereitstellen des Glassubstrats in einem zweiten Bereich, so dass das Glassubstrat genügend erhitzt wird, um es dem zweiten verbranntem Material zu ermöglichen, einen zweiten Wuchs direkt oder indirekt in oder auf dem ersten Wuchs zu bilden, wobei die Beschichtung zumindest die ersten und zweiten Wüchse aufweist, wobei die Konzentration von dem zweiten Precursor ungefähr 3 bis 4 mal größer ist als die Konzentration von dem ersten Precursor und wobei die Prozessbedingungen eine Flammentemperatur zwischen ungefähr 1000 bis 1400° C beinhalten, so dass der erste Wuchs eine kleine Keimbildungspartikel-Größenverteilung und der zweite Wuchs eine größere Aglomerat-Nanopartikel-Größenverteilung hat,
wobei die Beschichtung ein Oxid von Silizium aufweist,
wobei der erste Wuchs einen
Teilchengrößenverteilungsmittelwert von weniger als 10 nm hat und einen Film herstellen würde, der einen Brechungsindex von zwischen 1,43 bis 1,46 hat, wenn er selbstständig aufgebracht würde und
wobei der zweite Wuchs einen
Teilchengrößenverteilungsmittelwert von zwischen 10 bis 150 nm hat und einen Film herstellen würde, der einen Brechungsindex von zwischen 1,25 bis 1,42 hätte, wenn er selbstständig aufgebracht würde.

2. Das Verfahren gemäß Anspruch 1, wobei die Beschichtung die Transmission des Glassubstrats im Sichtbaren um zumindest 2,0 % erhöht.

3. Das Verfahren gemäß Anspruch 1, wobei die Beschichtung die Transmission des Glassubstrats im Sichtbaren um zumindest 3,0 bis 3,25 % erhöht.

4. Das Verfahren gemäß Anspruch 1, weiter bereitstellend erste und zweite Brenner zum jeweiligen Bereitstellen der ersten und zweiten Flammen.

5. Das Verfahren gemäß Anspruch 1, weiter aufweisend das Ablagern von einem oder mehreren zusätzlichen Wüchsen, wobei die zusätzlichen Wüchse mit kleiner Keimbildungspartikel-Größenverteilung und größerer Aglomerat-Nanopartikel-Größenverteilung hergestellt sind.

6. Das Verfahren gemäß Anspruch 1, weiter aufweisend das Vorbeiführen des Substrats unter der ersten und/oder zweiten Flamme zumindest zweimal zum Bilden einer Beschichtung aufweisend mehrere Wüchse, und wobei die mehreren Wüchse in kleiner Keimbildungspartikel-Größenverteilung und größerer Aglomerat-Nanopartikel-Größenverteilung alternieren.

7. Das Verfahren gemäß Anspruch 1, weiter aufweisend das Ablagern von zumindest einer zusätzlichen Beschichtung mittels Verbrennungsbeschichtung auf einer zweiten Oberfläche von dem Glassubstrat.

8. Ein beschichteter Gegenstand beinhaltend eine Beschichtung, getragen durch ein Glassubstrat, wobei die Beschichtung aufweist: zumindest zwei mit Verbrennungsbeschichtung abgelagerte Wüchse, die so angeordnet sind, dass die Wüchse insgesamt im Wesentlichen alternierend eine kleine Keimbildungspartikel-Größenverteilung und eine größere Aglomerat-Nanopartikel-Größenverteilung aufweisen, wobei die zumindest zwei mittels Verbrennungsbeschichtung abgelagerten Wüchse in einer gemischten oder abgestuften Art angeordnet sind und insgesamt eine Metalloxidmatrix bilden, die Nanopartikel beinhaltet, wobei die Nanopartikel darin in Situ eingebettet sind, und wobei die Beschichtung die Transmission des Glassubstrats im Sichtbaren um zumindest 2,0 % erhöht,
wobei die Beschichtung ein Oxid von Silizium aufweist,
wobei der erste Wuchs einen Teilchengrößenverteilungsmittelwert von weniger als ungefähr 10 nm hat und einen Film herstellen würde, der einen Brechungsindex von zwischen ungefähr 1,43 bis 1,46 hätte, wenn er selbstständig abgelagert würde und wobei der zweite Wuchs einen Teilchengrößenverteilungsmittelwert von zwischen ungefähr 10 bis 150 nm hat und einen Film produzieren würde, der einen Brechungsindex von zwischen ungefähr 1,25 bis 1,42 hätte, wenn er selbstständig abgelagert würde.

## Revendications

1. Un procédé de formation d'un revêtement sur un substrat en verre en utilisant un dépôt par combustion, le procédé comprenant :
l'obtention d'un substrat de verre présentant au moins une surface à revêtir ;
la sélection d'un réactif, le réactif étant sélectionné de telle sorte qu'au moins une partie du réactif soit utilisée pour former le revêtement ;
l'introduction d'un premier précurseur à consumer par une première flamme ;
la combustion d'au moins une partie du réactif et du premier précurseur pour former un premier matériau consumé, le premier matériau consumé comprenant un matériau non vaporisé ;
le placement du substrat en verre dans une première zone de telle sorte que le substrat en verre soit chauffé suffisamment pour permettre au premier matériau consumé de former une première croissance directement ou indirectement sur le substrat en verre ;
l'introduction d'un second précurseur à consumer par une seconde flamme ;
la combustion d'au moins une partie du réactif et du second précurseur pour former un second matériau consumé, le second matériau consumé comprenant un matériau non vaporisé ; et
le placement du substrat en verre dans une seconde zone de telle sorte que le substrat en verre soit chauffé suffisamment pour permettre au second matériau consumé de former une seconde croissance directement ou indirectement dans ou sur la première croissance, le revêtement comprenant au mois les première et seconde croissances, la concentration du second précurseur étant environ 3 à 4 fois supérieure à la concentration du premier précurseur et les conditions de processus comprenant une température de flamme comprise entre environ 1000 et 1400°C de telle sorte que la première croissance présente une distribution dimensionnelle réduite pour les particules de nucléation et la seconde croissance présente une distribution dimensionnelle plus grande pour les nanoparticules agglomérées, le revêtement comprenant un oxyde de silicium,
dans lequel la première croissance présente une moyenne de la distribution dimensionnelle des particules qui est inférieure à 10 nm, et
produirait un film présentant un indice de réfraction compris entre 1,43 et 1,46 si elle était revêtue indépendamment, et
dans lequel la seconde croissance présente une moyenne de la distribution dimensionnelle des particules qui est comprise entre 10 et 150 nm, et produirait un film présentant un indice de réfraction compris entre 1,25 et 1,42 si elle était revêtue indépendamment.

2. Le procédé de la revendication 1, dans lequel le revêtement augmente la transmission dans le visible du substrat en verre d'au moins 2,0 %.

3. Le procédé de la revendication 1, dans lequel le revêtement augmente la transmission dans le visible du substrat en verre d'une valeur comprise entre 3,0 et 3,25 %.

4. Le procédé de la revendication 1, avec en outre la mise en oeuvre d'un premier et d'un second bruleur pour produire respectivement les première et seconde flammes.

5. Le procédé de la revendication 1, comprenant en outre le dépôt d'une ou plusieurs croissances additionnelles, les croissances additionnelles étant réalisées avec une distribution dimensionnelle réduite pour les particules de nucléation et des distributions dimensionnelles plus grandes pour les nanoparticules agglomérées.

6. Le procédé de la revendication 1, comprenant en outre le passage du substrat sous la première et/ou la seconde flamme au moins deux fois pour former un revêtement comprenant des croissances multiples, et dans lequel les croissances multiples alternent une distribution dimensionnelle réduite pour les particules de nucléation et une distribution dimensionnelle plus grande pour les nanoparticules agglomérées.

7. Le procédé de la revendication 1, comprenant en outre le dépôt d'au moins un revêtement additionnel via un dépôt par combustion sur une seconde surface du substrat en verre.

8. Un article revêtu comprenant un revêtement supporté par un substrat en verre, le revêtement comprenant : au moins deux croissances déposées par dépôt par combustion qui sont disposées de telle sorte que les croissances comprennent collectivement une distribution dimensionnelle réduite pour les particules de nucléation alternant avec une distribution dimensionnelle plus grande pour les nanoparticules agglomérées, dans lequel les au moins deux croissances déposées par dépôt par combustion sont configurées de manière mélangée ou graduée et forment collectivement une matrice d'oxyde métallique comprenant des nanoparticules, les nanoparticules y étant incluses in situ, et dans lequel le revêtement augmente la transmission dans le visible du substrat en verre d'au moins environ 2,0 %, dans lequel le revêtement comprend un oxyde de silicium,
dans lequel la première croissance présente une moyenne des distributions dimensionnelles des particules inférieure à environ 10 nm, et produirait un film présentant un indice de réfraction compris entre environ 1,43 et 1,46 si elle était revêtue indépendamment, et dans lequel la seconde croissance présente une moyenne des distributions dimensionnelles des particules comprise entre environ 10 et 150 nm, et produirait un film présentant un indice de réfraction compris entre environ 1,25 et 1,42 si elle était revêtue indépendamment.
